# EUROPEAN PATENT APPLICATION

(11) **EP 4 715 865 A1**
(43) Date of publication of application: **25.03.2026**
(21) Application number: 25182705.1
(22) Date of filing: 13.06.2025
(51) Int. Cl.: H01J 37/32

(54) **METHOD OF ETCHING A SUBSTRATE**

(30) Priority: 20.09.2024 GB 202413908
(71) Applicant: SPTS Technologies Limited, NP18 2TA (GB)
(72) Inventor: MACNEIL, John, Newport (GB); ABIS, Laura, Newport (GB); RIDDELL, Kevin, Newport (GB)
(74) Representative: Wynne-Jones IP Limited

(57) **Abstract**

According to the invention there is provided a method of etching a substrate to produce a plurality of surface relief diffraction gratings comprising the steps of:
providing a dielectric substrate having a mask formed on an upper surface thereof, the mask comprising a plurality of apertures;
positioning the substrate on a substrate support in a chamber of a plasma etching apparatus;
positioning a Faraday cage so that an upper portion of the Faraday cage is disposed above the upper surface of the substrate and an electrical connection is maintained between the Faraday cage and the substrate support , wherein the upper portion of the Faraday cage comprises a plurality of discrete regions having open areas through which the substrate can be plasma etched; and
plasma etching the substrate to produce a plurality of surface relief diffraction gratings, wherein the plurality of surface relief diffraction gratings comprise at least two subsets having different angles and/or orientations;
in which:
the Faraday cage is positioned with the apertures of the mask and the discrete regions of the upper portion of the Faraday cage aligned so that plasma etching though the open areas produces the plurality of surface relief diffraction gratings; and
the discrete regions comprise at least two subsets wherein different subsets have open areas which have different angles and/or orientations with respect to the upper surface of the substrate so that plasma etching through the at least two subsets of discrete regions gives rise to the at least two subsets of surface relief diffraction gratings having different angles and/or orientations.

## Description

### Field of the Disclosure

This invention relates to a method of etching a substrate, with particular reference to a method of etching a substrate to produce a plurality of surface relief diffraction gratings. The invention relates also to an associated plasma etching apparatus.

### Background of the Disclosure

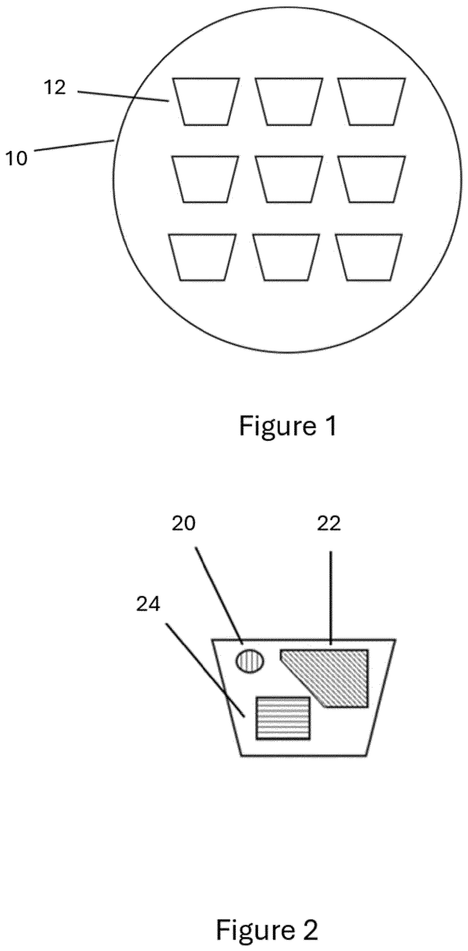

Surface relief diffraction gratings on waveguide combiners or coupler lenses are important elements for augmented reality (AR) and virtual reality (VR) systems. The surface relief diffraction gratings typically consist of a high refractive index (RI) glass, commonly comprising silicon oxide, etched at different angles and orientations. Figure 1 shows a substrate 10 containing multiple waveguide coupler lenses 12. The substrate 10 is typically a high RI glass. Figure 2 shows an individual waveguide coupler lens 12 in more detail. As shown in Figure 2, the waveguide coupler lens 12 comprises three different surface relief diffraction gratings 20, 22, 24, each grating being etched at different angles and orientations. In use, the image to be viewed is projected into first grating 20, which through total internal refection directs the light to second grating 22 which in turn directs the light to third grating 24, where the image is projected onto the user's eye. It is important that all lenses 12 on the substrate 10 are etched in a similar fashion. In the example illustrated in Figures 1 and 2, this involves providing each coupler lens 12 with three different surface relief diffraction gratings 20, 22, 24. The first, second and third gratings 20, 22, 24 are formed by etching features at different angles and at different orientations into the substrate 10. The etching can be performed to etch a "master" for nano imprint lithographic (NIL) printing or to etch the final product directly on the substrate.

The established method of etching angled features uses ion beam etching to produce a patterned substrate. However, these established methods have a number of significant disadvantages. In particular, etching three different surface relief diffraction gratings, such as that shown in Figures 1 and 2, with a conventional ion beam etch system requires three separate pattering and etch steps. Also, the etch rates associated with ion beam etching are generally low. The reasons for these disadvantages will now be explained.

Conventional ion beam systems use a plasma source with extraction grids to project beamlets of ions towards a substrate. To achieve acceptable uniformity the substrate needs to be placed remotely at a substantial distance from the source, resulting in relatively low etch rates. Typical ion beam etch rates are around 10-30nm/min, which compares unfavourably with the etch rates of around 100-1000nm/min which are readily achievable with conventional ICP etch systems. A further factor is that the beam is typically projected at low pressures (less than 1 mTorr) to minimize unwanted scattering of ions. As a result, ion beam systems are commonly large and complex and suffer from relatively low etch rates. Furthermore, multiple angled diffraction gratings, having gratings at different angles and orientations, require that the angle of the ion beam system is adjusted for each region on the waveguide combiner. This can be achieved by multiple patterning steps - using masks formed by sub-micron lithography - on the substrate, which is then exposed to the selected ion beam angle and orientation to etch the diffraction gratings. However, only one angle can be etched into the masked substrate at a time without compromising open features. As more than one angle and orientation are required to produce the different kinds of surface relief diffraction grating, the substrate must be removed from the vacuum system and repatterned before a subsequent feature can be generated with a different angle and/or orientation. It is highly undesirable from a process point of view to use multiple vacuum break and patterning steps. It would be highly desirable to provide a production technique which enables multiple surface relief diffraction gratings with different angles and orientations to be manufactured at superior etch rates and without requiring separate patterning steps.

### Statement of Invention

The present invention, in at least some of its embodiments, addresses the above described problems and desires. In particular, the present invention provides a method and associated apparatus which enable the simultaneous etching of multiple surface relief diffraction gratings with different angles and orientations. Although the invention is very well suited to the production of structures such as waveguide combiners or coupler lenses, the invention can be used to provide a wide range of surface relief diffraction gratings.

According to a first aspect of the invention there is provided a method of etching a substrate to produce a plurality of surface relief diffraction gratings comprising the steps of:
providing a dielectric substrate having a mask formed on an upper surface thereof, the mask comprising a plurality of apertures;
positioning the substrate on a substrate support in a chamber of a plasma etching apparatus;
positioning a Faraday cage so that an upper portion of the Faraday cage is disposed above the upper surface of the substrate and an electrical connection is maintained between the Faraday cage and the substrate support, wherein the upper portion of the Faraday cage comprises a plurality of discrete regions having open areas through which the substrate can be plasma etched; and
plasma etching the substrate to produce a plurality of surface relief diffraction gratings, wherein the plurality of surface relief diffraction gratings comprise at least two subsets having different angles and/or orientations;
in which:
   the Faraday cage is positioned with the apertures of the mask and the discrete regions of the upper portion of the Faraday cage aligned so that plasma etching through the open areas produces the plurality of surface relief diffraction gratings; and
   the discrete regions comprise at least two subsets wherein different subsets have open areas which have different angles and/or orientations with respect to the upper surface of the substrate so that plasma etching through the at least two subsets of discrete regions gives rise to the at least two subsets of surface relief diffraction gratings having different angles and/or orientations.

In this way, a plurality of surface relief diffraction gratings comprising a plurality of different angles and/or orientations can be produced in a single etching step. The method can be performed at relatively high etch rates. A further advantage is that it is easily possible to retrofit existing plasma etching apparatuses with a Faraday cage to provide an apparatus in accordance with the invention.

Without wishing to be bound by any particular theory or conjecture, it is believed that during etching a plasma sheath is formed parallel to the surface of the Faraday cage. It is further believed that a dark space region is formed above the Faraday cage so that ions can only enter the Faraday cage (via the open areas in the discrete regions) perpendicularly to the surface of the Faraday cage. This results in directional, anisotropic etching of the substrate.

The discrete regions can each comprise a mesh. The meshes provide the open areas through which the plasma can etch the substrate. It is understood that a Faraday cage is a structure which substantially or completely comprises conductive material and the meshes are envisaged to consist of conductive material. In principle, other structures or arrangements having open areas might be contemplated, such as a perforated structure. The perforated structure can be a perforated metal grid.

The upper portion of the Faraday cage can comprise a lid portion. The discrete regions of at least one subset can be housed in at least one walled housing which depends from the lid portion. Typically, the walled housing depends upwardly from the lid portion, although in principle walled housing might depend downwardly from the lid portion.

The Faraday cage can further comprise a skirt portion which downwardly depends from the upper portion. The step of positioning the Faraday cage can comprise bringing the skirt portion into contact with or close proximity to the substrate support. In practice, the skirt portion should be sufficiently close to the substrate support to prevent a plasma from striking within the Faraday cage.

At least one discrete region can comprise a sawtooth arrangement of repeat structures. Each repeat structure can comprise first and second oppositely inclined faces. The first face can contain open areas and the second face can be solid.

An electrical connection can be maintained between the Faraday cage and the substrate support at least in part via an electrically conductive flexible linking structure. Additionally, or alternatively, the electrical connection can be maintained by direct contact between the Faraday cage and the substrate support. It is desirable to achieve good Ohmic contact between the Faraday cage, including the discrete regions, and the substrate support.

An RF electrical signal can be applied to the substrate support during plasma etching of the substrate.

An inductively coupled plasma (ICP) is used to perform the plasma etching. ICP systems are advantageous because they can produce a high density plasma and provide high etch rates. ICP etching is particularly advantageous for etching oxides, where high energies are required. However, other plasma etching techniques, such as capacitively coupled plasma etching, might be used.

The dielectric substrate can be a glass.

The dielectric substrate can comprise silicon dioxide or borosilicate glass. However, the invention is not limited in this regard, and other materials which can be etched to provide a surface relief diffraction grating might be used. For example, the dielectric substrate can comprise SiC or LiNbO₃.

The Faraday cage can be formed from aluminium. Other conductive materials, such as other metals or metal alloys, might be envisaged. The open areas of the discrete regions are the only portions of the Faraday cage through which ions in the plasma are intended to pass. In practice, the rest of the Faraday cage structure typically comprises solid walls.

The Faraday cage can be provided as a one-piece structure. Alternatively, the Faraday cage can be provided in more than one pieces, for example a two-piece structure. A two-piece structure can comprise a lid portion and a separate skirt portion where, in use, the lid portion is brought into contact with the skirt portion.

The substrate support can be an electrostatic chuck (ESC).

According to a second aspect of the invention there is provided a plasma etching apparatus for etching a substrate to produce a plurality of surface relief diffraction gratings, the apparatus comprising:
a chamber;
a substrate support disposed within the chamber;
a plasma generation device for generating a plasma in the chamber;
a Faraday cage comprising an upper portion which can be disposed above the upper surface of a dielectric substrate positioned on the substrate support, wherein the upper portion comprises a plurality of discrete regions having open areas through which the substrate can be plasma etched, the discrete regions comprising at least two subsets wherein different subsets have open areas which have different angles and/or orientations with respect to an upper surface of the substrate support; and
a controller configured to control the apparatus to perform a method according to the first aspect of the invention.

The discrete regions can each comprise a mesh or a perforated structure.

The upper portion of the Faraday cage can comprise a lid portion.

The discrete regions of at least one subset can be housed in at least one walled housing which depends from the lid portion.

The Faraday cage can further comprise a skirt portion which downwardly depends from the upper portion.

At least one discrete region can comprise a sawtooth arrangement of repeat structures. Each repeat structure can comprise first and second oppositely inclined faces. The first face can contain open areas and the second face can be solid. In this way, etch uniformity within a given discrete region can be improved. The first and second oppositely inclined faces can be inclined at or close to an angle of 90°. In this way, losses of ions which have passed through the first face by collisions with the second face are minimized. Such losses might occur through scattering and shading by the second face of ions which otherwise would impact the substrate.

The upper portion of the Faraday cage can have a main level. Subsets of discrete regions which have different angles can be raised with respect to the main level by different extents in order to reduce variations in ion path length associated with etching through different subsets of discrete regions. Such variations can be referenced to the variations associated with having all discrete regions raised to the same extent in order to determine whether a reduction has been obtained. In this way, etch uniformity between different discrete regions having different angles with respect to the upper surface of the substrate support can be improved. Optimally, the discrete regions are raised so that the average ion path length through each discrete region is the same or substantially the same.

The apparatus can further comprise a lifting mechanism for lifting the Faraday cage with respect to the substrate support and lowering the Faraday cage into contact with or close proximity to the substrate support. The lifting mechanism can comprise any suitable components, such as one or more actuators and/or one or more lift pins. In general, the apparatus further comprises a separate lifting mechanism for the substrate, which can be part of a conventional handling mechanism for introducing and removing substrates to and from the chamber.

According to a third aspect of the invention there is provided a method of retrofitting a plasma etching apparatus to provide a plasma etching apparatus according to the second aspect of the invention, the method comprising the steps of: provisioning the apparatus with a Faraday cage comprising an upper portion which can be disposed above the upper surface of a dielectric substrate positioned on the substrate support, wherein the upper portion comprises a plurality of discrete regions having open areas through which the substrate can be plasma etched, the discrete regions comprising at least two subsets wherein different subsets have open areas which have different angles and/or orientations with respect to an upper surface of the substrate support; and adapting the controller to control the operation of the Faraday cage.

The method of retrofitting can further comprise provisioning the apparatus with a lifting mechanism for lifting the Faraday cage with respect to the substrate support and lowering the Faraday cage into contact with or close proximity to the substrate support.

For the avoidance of doubt, whenever reference is made herein to 'comprising' or 'including' and like terms, the invention is also understood to include more limiting terms such as 'consisting' and 'consisting essentially' where the context allows it.

Whilst the invention has been described above, it extends to any inventive combination of the features set out above, or in the following description, drawings or claims. Any features disclosed in relation to the first aspect of the invention may be combined with any features disclosed in relation to the second aspect of the invention and *vice versa* as appropriate.

### Description of the Drawings

Embodiments of the invention will now be described, by way of example only, with reference to the accompanying drawings, in which:
Figure 1 is a plan view of a substrate having multiple waveguide coupler lenses;
Figure 2 is a plan view of a waveguide coupler lens with three surface relief diffraction gratings;
Figure 3 is a cross-sectional semi-schematic view of a plasma etching apparatus of the invention;
Figure 4 is a cross sectional side view of a first Faraday cage and a substrate;
Figure 5 is a cross sectional side view of a second Faraday cage and a substrate; and
Figure 6 shows path length variation due to Faraday cage height, mesh angle and length.

### Detailed Description of the Disclosure

The invention uses a Faraday cage in a plasma etching apparatus to etch more than one angle and orientation in one etch cycle. In this way it is possible to simultaneously produce different surface relief diffraction gratings. Methods of the invention can be performed at a higher etch rate compared to an ion beam etch system.

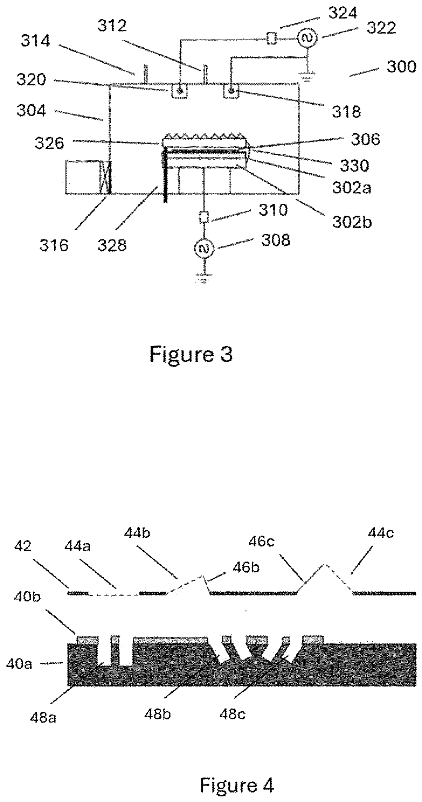

Figure 3 shows a plasma etching apparatus 300 of the invention. The plasma etch apparatus 300 is an inductively coupled plasma (ICP) apparatus such as an adapted Omega Synapse^{™} tool available from SPTS Technologies Limited of Newport, UK. The generation of a plasma within such a plasma etch apparatus is well-known in the art and will not be described here other than where necessary for an understanding of the present invention.

The plasma etch apparatus 300 shown in Figure 3 comprises a substrate support 302a/ 302b disposed within a chamber 304 for supporting a substrate 306. A bias power can be supplied to the substrate by a RF power supply 308 via an impedance matching network 310. The RF frequency can be any convenient value, such as 13.56 MHz or an alternative, lower frequency such as 400 KHz or 2 MHz. Process gas is delivered to the chamber through a central gas injector through pipe 312 and an annular radial series of injectors 314 which receive an independent flow of gas from pipe 312. The gases can be removed from the chamber 304 via an isolation valve 316 to a pumping system (not shown) in a conventional fashion. An ICP coil 318 is used to generate and sustain a plasma within the chamber 304. The ICP coil 318 is enclosed in ceramic container 320. As is known in the art, the ICP coil 318 receives RF power from a 13.56MHz power supply 322 through a matching network 324.

As shown in Figure 3, the substrate support is an electrostatic chuck (ESC) 302a which is attached to metallic platen 302b. A wafer substrate 306 is placed on the ESC 302a by conventional means using a vacuum robot and lift pins (not shown). A Faraday cage 326 is in the raised position through the use of an actuator 328. Following loading the actuator 328 lowers the Faraday cage 326 to be in close proximity or contact with the surface of the ESC 302a to avoid the initiation of a plasma within the Faraday cage 326. A conductive strap 330 electrically connects the Faraday cage 326 to the platen 302b. The ESC 302a can be of any suitable type. In one particular but non-limiting example, a bipolar ESC using helium backside gas at a pressure of ~10Torr was employed. A chiller unit can be provided to control the temperature of the substrate. As noted above, the apparatus 300 is an adapted commercially available tool. The adaptations principally consist of providing the Faraday cage and the lifting mechanism for the Faraday cage. It is understood that the apparatus 300 further comprises a microprocessor based controller (not shown in Figure 3) which controls the operation of the apparatus and that the controller is adapted to additionally control the Faraday cage and its lifting mechanism.

Figure 4 shows a configuration for a two piece Faraday cage which can be used in connection with the invention. Also shown in Figure 4 is a substrate 40a/ 40b on an ESC. The substrate comprises a SiO₂ layer on a silicon wafer (shown collectively in Figure 4 as 40a) with an aluminum mask 40b formed on the SiO₂ layer. The Faraday cage comprises a metal lid having a central section 42 which is shown in Figure 4 in a lowered position which is adopted for the etching step. The lowered position is adopted by lowering the lid including the central section 42 onto a skirt portion of the Faraday cage to provide an enclosure which is in electrical contact with an RF driven platen. The central section of the lid 42 comprises apertures which are each covered by a mesh which is in ohmic contact with the main body of the lid 42. A first mesh 44a is attached parallel with the surface of the lid while a second mesh 44b is angled at 30° to the surface of the lid and a third mesh 44c is angled at 45° to the surface of the lid. The second and third meshes are housed at the desired angles of inclination to the surface of the lid using walled housings which upwardly depend from the lid. Back walls 46b, 46c can be seen in Figure 4 although it is understood that each walled housing further comprises a pair of side walls (not shown).The walls of the walled housings are fabricated from a suitable material such as Al. As a result of this configuration, the only path for ions to reach the substrate is through the apertures in the mesh. A representative gap between the lid 42 and the surface of the substrate 40b is about 40mm. Etching results in the formation of diffraction grating features 48a, 48b and 48c which are broadly in agreement with the orientation of the mesh. Etch rates of up to 100nm/min can be readily achieved. It will be appreciated that the Faraday cage has multiple different zones through which etching can take place to provide multiple different diffraction grating structures. In this way, for example, a coupler lens of the type shown in Figure 2 can be produced which has discrete regions etched at different angles and orientations. For presentational simplicity, the skirt portion and the peripheral section of the lid of the Faraday cage are not shown in Figure 4. In practice, the lid is raised and lowered using a suitable lifting mechanism, for example using lift pins which pass through the wall of the skirt portion or extend through the substrate support to the interior of the skirt portion. In any event, the lifting mechanism for the substrate needs to be adapted to ensure that the substrate can be raised above the level of the skirt portion to enable the substrate to be loaded and unloaded.

Studies were conducted to characterize the etching a SiO₂ film on a silicon layer in a SPTS Synapse^{™} ICP tool using a Faraday cage broadly corresponding to the one shown in Figure 4. The Faraday cage has square apertures each of 25x25mm dimensions and covered with an aluminum mesh (380 micron openings/ 250 micron wire diameter) with three different orientations and angles.

Typically process conditions are :
ESC temperature 0°C.
ICP power 1.9kW (13.56MHz)
Bias power 325W (13.56MHz)
C₄F₈ flow: 50 sccm
O₂ flow: 8 sccm.

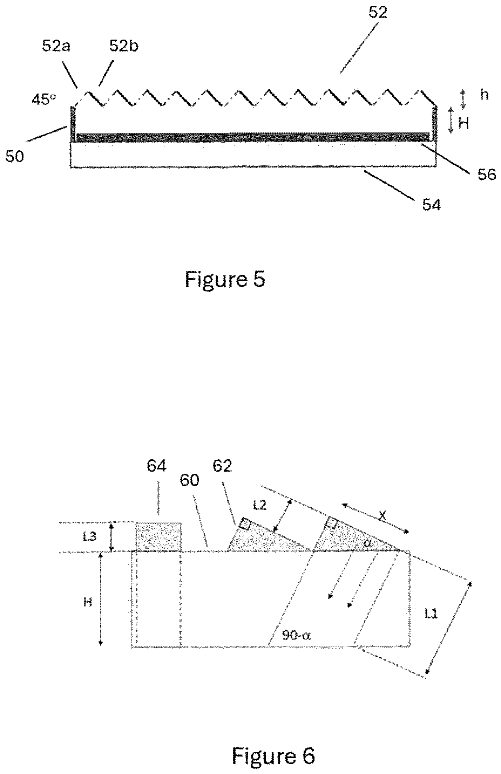

Ion energy reduces with increasing path length within the Faraday cage. Therefore, an increase in path length within the Faraday cage can be expected to give rise to a reduction in etch rate. Accordingly, a variation in ion path length within the Faraday cage can be expected to give rise to etch non-uniformities. The extent of the non-uniformity in etch rate will be determined in practice by a number of factors, which include ion path length, process conditions and the nature of the material being etched. For more chemical etch processes, the variation in path length becomes less significant. However, the present inventors have determined that with 25x25mm apertures of the type described in relation to Figure 4, etch uniformity could change by >10% depending on process parameters used. An alternative Faraday cage configuration can be used which addresses these issues. The alternative Faraday cage configuration can provide greater process flexibility and enhance large scale implementation of the present invention by utilizing a mesh height which can be tuned to minimize non-uniformity of the etched grating. Figure 5 shows an alternative Faraday cage configuration comprising a skirt portion 50 and a lid portion 52. The skirt portion 50 is placed on an ESC 54. The ESC supports a substrate 56. The lid portion comprises a sawtooth arrangement of repeat structures 52a /52b, each repeat structure comprising first 52a and second 52b oppositely inclined faces, wherein the first face 52a is a mesh and the second face 52b is a solid back wall. Each repeat structure further comprises a pair of side walls (not shown). There is a 90° angle between a mesh 52a and the corresponding back wall 52b of a repeat structure which minimizes scattering and shading of ions impacting the wafer substrate 56. By tuning process conditions together with H (the height of the Faraday Cage to the lid) and h (the height to the apex of the feature), etch rate and non-uniformity can be optimized by acting on the ion path length. The repeat structures 52a/52b shown in Figure 5 correspond to a single inclined mesh/ back wall structure such as the structure 44b/46b or the structure 44c/46c shown in Figure 4. The sawtooth arrangement can comprise any suitable number of repeat structures of any suitable size. For example, the 25mm width referred to in Figure 4 can be provided instead as a sawtooth arrangement comprising three 8.3mm sections. This significantly reduces the difference in ion path length when comparing ions incident on the top of the mesh to ions incident on the lower part of the mesh close to the surface of the Faraday Cage lid. In other words, this arrangement reduces the difference in ion path length associated with etching through a single discrete region, which in Figure 5 is a mesh arrangement which results in the formation of one diffraction grating. By doing so, etch uniformity is improved in respect of the etching of a given diffraction grating.

Factors which can influence the detailed design of a sawtooth arrangement such as that shown in Figure 5 will now be discussed. Figure 6 shows a Faraday Cage lid 60 with a plurality of tooth enclosures 62 each having a length X and an angle (α). It can be appreciated that the variation in ion path lengths is determined by the L1 and L2 components, where L1 is dependent on the height H and the angle α, and L2 is dependent on the angle α and the length X. From this, it can be seen that the additional path length L2 can be reduced by reducing X. For example, by reducing X by a third, L2 is reduced also by a third. This will result in an improvement in the etch rate uniformity. Also, it can be seen that differences in etch uniformity between different discrete regions can occur due to differences in average ion path length which can occur between different discrete regions. Figure 6 shows also a discrete region in which the mesh is parallel to the surface of the lid. In order to ensure uniformity at different angles, it is important to maintain the same path length. Therefore, the plane of the mesh which is parallel to the surface of the lid 60 in Figure 6 is raised to the average path length associated with enclosure 62. As shown in Figure 6, this raised configuration can be achieved by housing the mesh in an enclosure 64 which retains the mesh parallel with the surface of the lid 60 but with the mesh raised a height L3 above the main surface of the lid 60. The extent to which any given mesh is raised will depend on the angle α.

It will be apparent that the invention can be implemented in various ways. Although ICP etching is an attractive option because relatively high etch rates can be readily achieved, etch systems, such as capacitively coupled, helicon, RIE or microwave type apparatus, can be used. The skilled reader will understand that the invention can be applied to the production of a wide range of diffraction gratings and end applications.

## Claims

1. A method of etching a substrate to produce a plurality of surface relief diffraction gratings comprising the steps of:
providing a dielectric substrate having a mask formed on an upper surface thereof, the mask comprising a plurality of apertures;
positioning the substrate on a substrate support in a chamber of a plasma etching apparatus;
positioning a Faraday cage so that an upper portion of the Faraday cage is disposed above the upper surface of the substrate and an electrical connection is maintained between the Faraday cage and the substrate support, wherein the upper portion of the Faraday cage comprises a plurality of discrete regions having open areas through which the substrate can be plasma etched; and
plasma etching the substrate to produce a plurality of surface relief diffraction gratings, wherein the plurality of surface relief diffraction gratings comprise at least two subsets having different angles and/or orientations;
in which:
the Faraday cage is positioned with the apertures of the mask and the discrete regions of the upper portion of the Faraday cage aligned so that plasma etching through the open areas produces the plurality of surface relief diffraction gratings; and
the discrete regions comprise at least two subsets wherein different subsets have open areas which have different angles and/or orientations with respect to the upper surface of the substrate so that plasma etching through the at least two subsets of discrete regions gives rise to the at least two subsets of surface relief diffraction gratings having different angles and/or orientations.

2. A method according to claim 1, in which the discrete regions each comprise a mesh or a perforated structure; and/or
in which the upper portion of the Faraday cage comprises a lid portion, preferably in which the discrete regions of at least one subset are housed in at least one walled housing which depends from the lid portion.

3. A method according to any previous claim, in which the Faraday cage further comprises a skirt portion which downwardly depends from the upper portion, optionally in which the step of positioning the Faraday cage comprises bringing the skirt portion into contact with or close proximity to the substrate support.

4. A method according to any previous claim, in which at least one discrete region comprises a sawtooth arrangement of repeat structures, each repeat structure comprising first and second oppositely inclined faces, wherein the first face contains open areas and the second face is solid.

5. A method according to any previous claim, in which an electrical connection is maintained between the Faraday cage and the substrate support at least in part via an electrically conductive flexible linking structure.

6. A method according to any previous claim, in which an RF electrical signal is applied to the substrate support during plasma etching of the substrate.

7. A method according to any previous claim, in which:
a) an inductively coupled plasma (ICP) is used to perform the plasma etching; and/or
b) the Faraday cage is formed from aluminium; and/or
c) the substrate support is an electrostatic chuck (ESC).

8. A method according to any previous claim in which the dielectric substrate is a glass, or in which the dielectric substrate comprises silicon dioxide or borosilicate glass.

9. A plasma etching apparatus for etching a substrate to produce a plurality of surface relief diffraction gratings, the apparatus comprising:
a chamber;
a substrate support disposed within the chamber;
a plasma generation device for generating a plasma in the chamber;
a Faraday cage comprising an upper portion which can be disposed above the upper surface of a dielectric substrate positioned on the substrate support, wherein the upper portion comprises a plurality of discrete regions having open areas through which the substrate can be plasma etched, the discrete regions comprising at least two subsets wherein different subsets have open areas which have different angles and/or orientations with respect to an upper surface of the substrate support; and
a controller configured to control the apparatus to perform a method according to claim 1.

10. A plasma etching apparatus according to claim 9 in which the discrete regions each comprise a mesh or a perforated structure.

11. A plasma etching apparatus according to claim 9 or claim 10 in which the upper portion of the Faraday cage comprises a lid portion, optionally in which the upper portion of the Faraday cage in which the discrete regions of at least one subset are each housed in a walled housing which depends from the lid portion.

12. A plasma etching apparatus according to any one of claims 9 to 11 in which the Faraday cage further comprises a skirt portion which downwardly depends from the upper portion.

13. A plasma etching apparatus according to any one of claims 9 to 12 in which at least one discrete region comprises a sawtooth arrangement of repeat structures, each repeat structure comprising first and second oppositely inclined faces, wherein the first face contains open areas and the second face is solid, optionally in which the first and second oppositely inclined faces are inclined at or close to an angle of 90°.

14. A plasma etching apparatus according to any one of claims 9 to 13 in which the upper portion of the Faraday cage has a main level and subsets of discrete regions which have different angles with respect to the upper surface of the substrate support are raised with respect to the main level by different extents in order to reduce variations in ion path length associated with etching through different subsets of discrete regions.

15. A plasma etching apparatus according to any one of claims 9 to 13 further comprising a lifting mechanism for lifting the Faraday cage with respect to the substrate support and lowering the Faraday cage into contact with or close proximity to the substrate support.
